# EUROPEAN PATENT APPLICATION

(11) **EP 4 746 670 A1**
(43) Date of publication of application: **20.05.2026**
(21) Application number: 25202063.1
(22) Date of filing: 15.09.2025
(51) Int. Cl.: H10P 72/00, H10P 72/76

(54) **SUBSTRATE PROCESSING APPARATUS AND SUBSTRATE PROCESSING SYSTEM INCLUDING THE SAME**

(30) Priority: 24.09.2024 JP 2024165266
(71) Applicant: SCREEN Holdings Co., Ltd., Kyoto-shi, Kyoto 602-8585 (JP)
(72) Inventor: NISHIYAMA, Koji, Kyoto, 602-8585 (JP)
(74) Representative: Kilian Kilian & Partner mbB

(57) **Abstract**

Outside air is taken into a liquid recovery chamber in a cup (19) through a first flow path which is a ring-shaped gap located between an outer tapered portion and a substrate held by a spin chuck (9), outside air taken into the liquid recovery chamber is taken into a gas recovery chamber through a second flow path which is a cylindrical gap located between a middle wall portion and a lower wall portion of a lower cup (30), and the outside air is discharged from an exhaust opening. A flow path cross-sectional area of the second flow path is equal to a cross-sectional area of the first flow path.

## Description

### Background of the invention

The present invention relates to a substrate processing apparatus for forming a photoresist layer and a substrate processing system including the same. The substrate is, for example, a semiconductor wafer, a substrate for a liquid crystal display, a substrate for organic electroluminescence (El), a substrate for a flat panel display (FPD), a substrate for an optical display, a substrate for a magnetic disk, a substrate for an optical disk, a substrate for a magneto-optical disk, a substrate for a photomask, or a substrate for a solar cell.

### Description of the Related Art

JP H11-33468 A describes a substrate processing apparatus including a cup including an upper cup and a lower cup, and a straightening plate provided below a rotation holding portion. The straightening plate has an inclined surface inclined obliquely downward toward an outer periphery. According to the configuration of JP H11-33468 A, a small hole for washing away processing liquid attached to a surface of the straightening plate is provided.

### <List of documents>

JP H11-33468 A

However, according to the configuration described above, stains are likely to adhere to the straightening plate, and the straightening plate needs to be cleaned at a high frequency. Since the straightening plate is located inside the cup, it is necessary to disassemble the cup in order to take out the straightening plate from the substrate processing apparatus to wash the straightening plate. This causes deterioration in processing efficiency of the substrate processing apparatus, and an increase in consumption of cleaning chemical liquid.

The present invention has been made in view of such circumstances, and an object of the present invention is to provide a substrate processing apparatus and a substrate processing system for reducing a frequency of cleaning processing that requires disassemble of a cup, having high processing efficiency, and for reducing consumption of chemical liquid used for cleaning.

### Summary of the invention

The present invention has the following configuration in order to solve the above-described problem.

That is, a substrate processing apparatus according to the present invention includes:
a spin chuck that is rotatable while holding a substrate;
a nozzle located upward of the spin chuck and configured to discharge liquid; and
a cup provided to surround the spin chuck, in which
the cup includes an upper cup, a lower cup, and a middle cup,
the upper cup includes an outer tapered portion having a ring shape and having an inner diameter gradually decreasing upward,
the lower cup includes: a bottom surface having a ring shape; an outer housing having a cylindrical shape, provided to extend upward from an outer edge portion of the bottom surface, and having an upper portion connected to a lower portion of the upper cup; an inner housing having a cylindrical shape and provided to extend upward from an inner edge portion of the bottom surface; and a lower wall portion having a cylindrical shape and provided to extend upward from the bottom surface between the outer housing and the inner housing, a space formed by being sandwiched between the outer housing and the lower wall portion serves as a liquid recovery chamber, a space sandwiched between the inner housing and the lower wall portion serves as a gas recovery chamber, and the bottom surface is provided with an exhaust port communicatively connected to the gas recovery chamber and configured to exhaust an atmosphere in the cup,
the middle cup is located at a position sandwiched from above and below by the upper cup and the lower cup, and includes: a middle wall portion having a cylindrical shape, provided to face the lower wall portion of the lower cup on a radially outer side of the lower wall portion, having a lower end terminating at a middle position of the liquid recovery chamber, and having an upper end terminating at a position facing an upper end of the lower wall portion; and an inner tapered portion having a ring shape, connected from an upper end of the middle wall portion, and having a diameter gradually decreasing upward, and
outside air is taken into the liquid recovery chamber in the cup through a first flow path that is a ring-shaped gap located between the outer tapered portion in the upper cup and the substrate held by the spin chuck, and outside air taken into the liquid recovery chamber is taken into the gas recovery chamber through a second flow path and is discharged from the exhaust port, the second flow path being a cylindrical gap located between the middle wall portion and the lower wall portion in the lower cup, and a flow path cross-sectional area of the second flow path is equal to a cross-sectional area of the first flow path.

[Operation and Effect] The substrate processing apparatus described above includes the outer housing having a cylindrical shape, and the outer tapered portion having a ring shape, located upward of the outer housing, and having an inner diameter gradually decreasing upward from an inner diameter of the outer housing. The gap between the outer tapered portion and the substrate held by the spin chuck serves as the first flow path. In the substrate processing apparatus described above, the gap between the middle wall portion of the middle cup and the lower wall portion of the lower cup serves as the second flow path. Then, the flow path cross-sectional area of the second flow path is equal to the cross-sectional area of the first flow path. With this configuration, the middle cup can be made as small as possible.

That is, in order to inhibit contamination of the middle cup due to liquid discharged from the nozzle, it suffices that the middle cup is made as small as possible. Specifically, the middle wall portion of the middle cup may be simply brought closer to the lower wall portion of the lower cup to make the middle cup smaller. A lower limit of the size of the middle cup can be set by determining a dimension of the middle wall portion on the basis of the cross-sectional area of the first flow path, which is the gap between the outer tapered portion of the upper cup and the substrate held by the spin chuck. If the size of the middle cup is reduced independently of the cross-sectional area of the first flow path, an airflow in the gap between the outer tapered portion of the upper cup and the substrate held by the spin chuck is weakened. According to the present invention, such a phenomenon does not occur. Therefore, according to the present invention, it is possible to provide a substrate processing apparatus capable of suppressing adhesion of stains to the middle cup while appropriately executing substrate processing.

In the substrate processing apparatus described above,
the bottom surface of the lower cup preferably includes a liquid discharge port provided at a position farther from the spin chuck than the lower wall portion and configured to discharge liquid in the cup, and
the middle cup is preferably entirely located inside the spin chuck with reference to a straight line connecting a center of the liquid discharge port and an end portion of a substrate held by the spin chuck.

[Operation and Effect] According to the configuration described above, the bottom surface of the lower cup includes the liquid discharge port provided at a position farther from the spin chuck than the lower wall portion and configured to discharge liquid in the cup, and the middle cup is entirely located inside the spin chuck with reference to a straight line connecting the center of the liquid discharge port and an end portion of a substrate held by the spin chuck. That is, most of liquid during substrate processing is discharged from the liquid discharge port without reaching the inner tapered portion. With this configuration, the middle cup can be located away from a flow of the liquid when the liquid in the cup is discharged. Therefore, according to the present configuration, it is possible to provide a substrate processing apparatus capable of suppressing adhesion of stains to the middle cup.

In the substrate processing apparatus described above,
a distance in a vertical direction between the inner tapered portion of the middle cup and the lower wall portion of the lower cup is preferably longer than a separation distance.

[Operation and Effect] According to the configuration described above, a distance in the vertical direction between the inner tapered portion of the middle cup and the lower wall portion of the lower cup is longer than the separation distance.
With this configuration, an airflow in a gap between the inner tapered portion of the middle cup and the lower wall portion of the lower cup can be made weaker than an airflow in a gap between the middle wall portion and the lower wall portion. That is, with such a configuration, it is possible to provide a substrate processing apparatus in which the airflow in the gap between the outer tapered portion of the upper cup and the substrate held by the spin chuck is reliably maintained.

In the substrate processing apparatus described above,
the middle cup preferably includes a vertical wall portion having a cylindrical shape and connected with an upper end of the inner tapered portion, and
an outer diameter of the vertical wall portion is preferably smaller than a diameter of the substrate.

[Operation and Effect] According to the configuration described above, the middle cup includes the vertical wall portion having a cylindrical shape and connected with the upper end of the inner tapered portion, and the outer diameter of the vertical wall portion is smaller than the diameter of the substrate. With this configuration, liquid scattered from the end portion of the substrate goes toward the lower cup while avoiding the vertical wall portion. With this configuration, it is possible to provide a substrate processing apparatus having a configuration in which the liquid does not reach the middle cup as much as possible.

This specification also describes a substrate processing system including the substrate processing apparatus described above.

That is, the substrate processing system according to the present invention includes the substrate processing apparatus described above and a robot that takes a substrate in and out of the substrate processing apparatus.

According to the present invention, it is possible to provide a substrate processing apparatus and a substrate processing system including the substrate processing apparatus for reducing a frequency of cleaning processing that requires disassemble of a cup, having high processing efficiency, and for reducing consumption of chemical liquid used for cleaning.

### Brief of description of the drawings

FIG. 1 is a plan view for explaining an overall configuration of a substrate processing system according to an embodiment;
FIG. 2 is a cross-sectional view for explaining a substrate processing chamber according to the embodiment;
FIG. 3 is a cross-sectional view for explaining a flow of an atmosphere in a cup according to the embodiment;
FIG. 4 is a cross-sectional view for explaining a flow of chemical liquid in the cup according to the embodiment;
FIG. 5 is a cross-sectional view for explaining an up and down movement of the cup according to the embodiment;
FIG. 6 is a perspective view for explaining an effect according to the embodiment;
FIG. 7 is a schematic diagram for explaining an effect according to the embodiment;
FIG. 8 is a cross-sectional view for explaining a shape of the cup according to the embodiment; and
FIG. 9 is a cross-sectional view for explaining a shape of a cup according to a modification of the present invention.

### Description of the preferred embodiments

A substrate processing apparatus according to the present invention is mounted on, for example, a substrate processing system that processes a semiconductor substrate. Therefore, as a mode for carrying out the present invention, a substrate processing system that performs necessary processing before and after exposure processing in a photolithography step will be described as an example

### Embodiment

### <1. Overall Configuration>

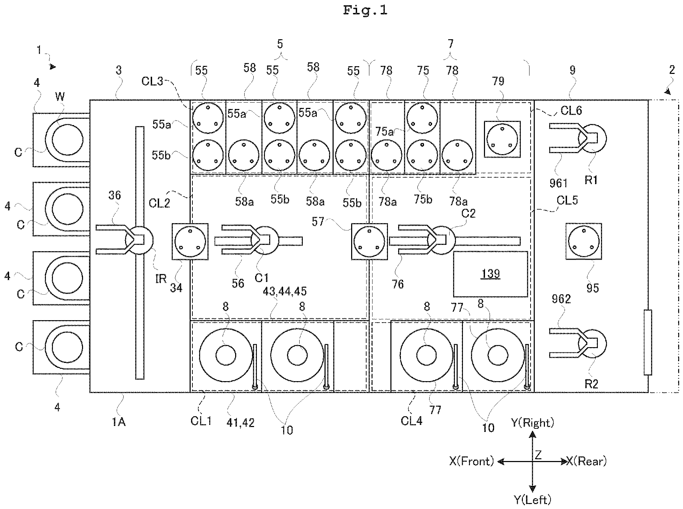

FIG. 1 is a plan view illustrating an overall configuration of a substrate processing apparatus of the present example. A substrate processing apparatus 1 of the present example is connected to an exposure machine 2 for exposure, which is an external device. The substrate processing apparatus 1 further includes an indexer block 3, a coater block 5, a developer block 7, and an interface block 9. The indexer block 3, the coater block 5, the developer block 7, and the interface block 9 are arranged in this order to form the substrate processing apparatus 1. The substrate processing apparatus 1 includes a housing 1A that houses each block. The housing 1A has a substantially rectangular shape in plan view. A load port 4 is provided to protrude from a wall surface on one end side of the housing 1A.

In this specification, for convenience, a direction in which the indexer block 3, the coater block 5, the developer block 7, and the interface block 9 in the substrate processing apparatus 1 are arranged is referred to as a front-rear direction (X direction). The X direction extends horizontally. A direction from the coater block 5 toward the indexer block 3 in the substrate processing apparatus 1 is referred to as front. A direction opposite to the front is referred to as rear. A horizontal direction orthogonal to the X direction is referred to as a left-right direction (Y direction). The Y direction is also a direction in which a plurality of load ports 4 are arranged. One side in the Y direction is referred to as a right side for convenience, and a direction opposite to the right side is referred to as a left side. A height direction (Z direction) is orthogonal to both the X direction and the Y direction, and coincides with a vertical direction. In each figure, front, rear, right, left, up, and down are illustrated as appropriate for reference.

### <2. Indexer Block>

As illustrated in FIG. 1, the indexer block 3 includes the load port 4 which is an entrance when a carrier C storing a plurality of substrates W in a horizontal orientation at predetermined intervals in the Z direction is input into the block. The carrier C can be placed in the load port 4.

A plurality of (for example, 25) substrates W are stacked and stored in one carrier C. The carrier C storing the unprocessed substrates W carried into the substrate processing apparatus 1 is first placed in the load port 4.

In the indexer block 3, an indexer robot IR capable of conveying substrates W in the horizontal orientation one by one is disposed. The indexer robot IR can access a pass 34 provided at a boundary between the indexer block 3 and the coater block 5 illustrated in FIG. 1 and can access any of the four load ports 4, and transfers the substrate W between the pass 34 and the carrier C installed in the load port 4. The transfer of the substrate W by the indexer robot IR is achieved by a hand 36.

### <3. Coater block>

The coater block 5 has a configuration in which a photoresist layer is mainly formed on the substrate W before exposure processing. The coater block 5 includes a second row CL2 located on the rear side of the pass 34, a first row CL1 provided on the left side of the second row CL2, and a third row CL3 provided on the right side of the second row CL2. Therefore, the second row CL2 is located at a position sandwiched between the first row CL1 and the third row CL3 from left and right.

In the first row CL1, chemical liquid processing chambers are arranged in the X direction. The chemical liquid processing chamber includes a spin chuck 8 that is rotatable while holding the substrate W, and a nozzle 10 that is located upward of the spin chuck 8 and discharges chemical liquid. Therefore, the chemical liquid processing chamber is configured to apply the chemical liquid to a surface of the substrate W. The chemical liquid processing chamber includes a vacuum chamber 45 for film formation of an antireflection film, and resist chambers 41, 42, 43, and 44 for film formation of a photoresist layer. In the first row CL1 of FIG. 1, a state is described in which two of the resist chambers 41, 42, 43, and 44 or two vacuum chambers 45 are arranged in the front-rear direction. In the first row CL1, the vacuum chamber 45 and the resist chambers 41, 42, 43, and 44 are stacked across three layers. A vertical relationship between the vacuum chamber 45 and the resist chambers 41, 42, 43, and 44 can be appropriately switched. Further, in the first row CL1, four or more chemical liquid processing chambers may be stacked.

An edge exposure unit is provided in the third row CL3 to be described later or a sixth row CL6 in the developer block 7 to be described later. The edge exposure unit can perform edge exposure related to removal of a photoresist layer at a peripheral edge portion of the substrate W.

The second row CL2 is a passage through which a first center robot C1 that conveys the substrate W in the horizontal orientation moves forward and rearward. In addition to the pass 34 described above, the first center robot C1 can access the vacuum chamber 45 and the resist chambers 41, 42, 43, and 44 provided in the first row CL1, a heat processing chamber 55 and a cooling unit 58 described later provided in the third row CL3, and a pass 57 provided at a boundary between the coater block 5 and the developer block 7 illustrated in FIG. 1. The resist chambers 41, 42, 43, and 44 correspond to a substrate processing chamber in the present invention.

The first center robot C1 is movable forward and backward in the X direction and movable upward and downward in the Z direction so as to be able to convey the substrate W to each accessible position. Then, the first center robot C1 can direct a hand 56 holding the substrate W to any of the front, rear, left, and right.

In the third row CL3, the heat processing chamber 55 that heats the substrate W and the cooling unit 58 that cools the substrate W are arranged in the X direction. In the heat processing chamber 55, a circular hot plate 55a that heats the substrate W and a circular post-heating processing plate 55b that performs post-heating processing for lowering a temperature of the high-temperature substrate W are arranged in the Y direction. Whereas, the cooling unit 58 is provided with a circular cooling processing plate 58a that cools the substrate W at room temperature. In the third row CL3, in addition to being arranged in the X direction, the heat processing chambers 55 or the cooling units 58 are also stacked in the Z direction to form a multilayer body of chambers. The number of layers included in the multilayer body can be appropriately changed.

### <4. Developer Block>

The developer block 7 is configured to mainly develop the substrate W after the exposure processing. The developer block 7 includes a fifth row CL5 located on the rear side of the pass 57, a fourth row CL4 provided on the left side of the fifth row CL5, and the sixth row CL6 provided on the right side of the fifth row CL5. Therefore, the fifth row CL5 is located at a position sandwiched between the fourth row CL4 and the sixth row CL6 from left and right.

In the fourth row CL4, development chambers 77 are arranged in the X direction. The development chamber 77 has the spin chuck 8 that rotatably supports the substrate W, and the nozzle 10 that discharges chemical liquid. The fourth row CL4 of FIG. 1 shows a state in which two development chambers 77 are arranged in the front-rear direction. In the fourth row CL4, the development chambers 77 are stacked. The number of layers included in a multilayer body including the development chambers 77 can be appropriately changed.

The fifth row CL5 is a passage through which a second center robot C2 that conveys the substrate W in the horizontal orientation moves forward and rearward. In addition to the pass 57 described above, the second center robot C2 can also access the development chamber 77 included in the fourth row CL4, and a heat processing chamber 75, a cooling unit 78, and a pass 79 described later provided in the sixth row CL6.

Similarly to the first center robot C1, the second center robot C2 is movable forward and backward in the X direction and movable upward and downward in the Z direction so as to be able to convey the substrate W to each accessible position. Then, the second center robot C2 can direct a hand 76 holding the substrate W to at least any of the front, left, and right.

In the sixth row CL6, the heat processing chamber 75 that heats the substrate W and the cooling unit 78 that cools the substrate W are arranged in the X direction. The heat processing chamber 75 has a configuration similar to that of the heat processing chamber 55 in the third row. Therefore, the heat processing chamber 75 is configured by arranging a circular hot plate 75a and a circular post-heating processing plate 75b in the Y direction. The cooling unit 78 has a configuration similar to that of the cooling unit 58 of the third row CL3. Therefore, the cooling unit 78 is provided with a circular cooling processing plate 78a.

The pass 79 is provided at a rear end portion of the sixth row CL6. The substrate W in the horizontal orientation can move back and forth between the developer block 7 and the interface block 9 via the pass 79.

### <5. Interface Block>

The interface block 9 includes a pass 95 capable of cooling the placed substrate W, a first robot R1 capable of accessing the pass 95 and the above-described pass 79, and a second robot R2 capable of accessing the pass 95 and the exposure machine 2. The first robot R1 includes a hand 961 capable of gripping the substrate W in the horizontal orientation placed on the pass 79, and the second robot R2 includes a hand 962 capable of gripping the substrate W in the horizontal orientation placed on the pass 95.

The passes 95 are stacked in the Z direction to form a multilayer body.

### <6. Exposure Machine>

The exposure machine 2 receives the substrate W before the exposure processing conveyed by the second robot R2, performs the exposure processing, and burns a circuit pattern of a device on the photoresist layer of the substrate W. The substrate W after the exposure processing is passed to the second robot R2. Specific configuration examples of the exposure machine 2 include a stepper and a scanner.

### <7. Control Unit>

As illustrated in FIG. 1, the substrate processing apparatus 1 includes a control unit 139 related to control of the apparatus. Although not illustrated in FIG. 1, the control unit 139 is provided with a corresponding storage unit. The control unit 139 includes, for example, a central processing unit (CPU). A specific configuration of the control unit is not limited, and for example, different types of control related to the substrate processing apparatus 1 may be configured by a single processor, or different types of control may be configured by individual processors.

Examples of the control related to the control unit 139 include control related to the indexer robot IR, the first center robot C1, the second center robot C2, the first robot R1, and the second robot R2.

The storage unit stores a program, parameters, and the like related to control. The storage unit may be configured by a single device or may be configured by individual devices corresponding to different types of control. In addition, the substrate processing apparatus 1 of the present example is not particularly limited to the configuration of the device that implements the storage unit.

### <8. Resist Chamber>

The resist chamber 41 corresponds to a substrate processing apparatus in the present invention. Hereinafter, a specific configuration of the resist chamber 41 will be described in detail.

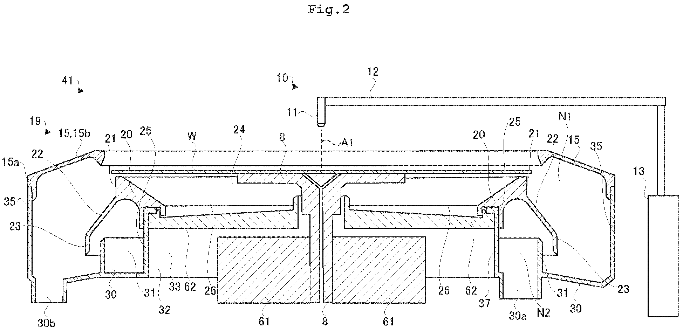

FIG. 2 is a cross-sectional view for explaining a configuration of the resist chamber 41. As illustrated in FIG. 2, the resist chamber 41 includes the spin chuck 8 that rotatably supports the substrate W, and the nozzle 10 provided above the spin chuck 8. The nozzle 10 is configured to discharge chemical liquid, and includes a nozzle head 11 that discharges the chemical liquid toward the substrate W, an arm 12 that supports the nozzle head 11, and a turning mechanism 13 that turns the arm 12. The spin chuck 8 is a vacuum chuck that suctions and holds the substrate W. Specific examples of the chemical liquid include a photoresist, an antireflection film forming liquid, a glass film forming liquid, and a protective film forming liquid. Furthermore, a plurality of nozzles 10 (not illustrated) may be provided, and a nozzle for discharging a solvent may be provided in addition to the above-described nozzle that discharges the chemical liquid. Examples of the solvent include organic solvents such as thinner, propylene glycol monomethyl ether (PGME), propylene glycol monomethyl ether (PGMEA), ethyl lactate, cyclohexane, 4-Methyl-2 pentanol (MIBC), and isopropyl alcohol (IPA).

A cup 19 is provided to surround the spin chuck 8. The cup 19 is configured to inhibit scattering of the chemical liquid inside the resist chamber 41. The cup 19 includes a ring-shaped upper cup 15, a lower cup 30 to be fitted to the upper cup 15, and a middle cup 20. The middle cup 20 has a ring shape provided in a space formed when the upper cup 15 and the lower cup 30 are combined. Each of the upper cup 15, the lower cup 30, and the middle cup 20 is a rotational body, and a central axis of the rotational body coincides with a rotation axis of the spin chuck 8.

The upper cup 15 includes a fitting portion 15a to be fitted to the lower cup 30, and an outer tapered portion 15b having a shape in which a diameter decreases upward from the fitting portion 15a. The outer tapered portion 15b has a ring shape in which an inner diameter gradually decreases upward.

The lower cup 30 includes an outer housing 35 having a cylindrical shape, and a bottom plate 32 having a ring shape and provided to close a lower side of the outer housing 35. The outer housing 35 is provided to extend upward from an outer edge portion of the bottom plate 32 constituting a bottom surface, and has a cylindrical shape in which an upper portion thereof is connected to the fitting portion 15a constituting a lower portion of the upper cup 15. In addition, the lower cup 30 has a lower wall portion 31 having a cylindrical shape and provided to protrude from the bottom plate 32, and a cylindrical inner housing 37 that defines an inner surface of the lower cup 30. The inner housing 37 has a cylindrical shape and is provided to extend upward from an inner edge portion of the bottom plate 32.

The lower wall portion 31 has a cylindrical shape and is provided between the outer housing 35 and the inner housing 37, so as to extend upward from the bottom surface of the bottom plate 32.

A space formed by being sandwiched between the outer housing 35 and the lower wall portion 31 is a liquid recovery chamber N1 that recovers liquid discharged from the nozzle and dropped from the upper surface of the substrate W. A space sandwiched between the inner housing 37 and the lower wall portion 31 is a gas recovery chamber N2 communicating with an exhaust opening 30a described later.

The bottom plate 32 of the lower cup 30 is provided with a plurality of openings. A circular liquid discharge opening 30b provided in the bottom plate 32 is an outlet of chemical liquid for the resist chamber 41. The liquid discharge opening 30b is provided at a position closer to the outer housing 35 than the lower wall portion 31. The liquid discharge opening 30b corresponds to a liquid discharge port in the present invention. The bottom plate 32 of the lower cup 30 includes a liquid discharge opening that discharges liquid in the cup 19 and is provided at a position farther from the spin chuck 8 than the lower wall portion 31.

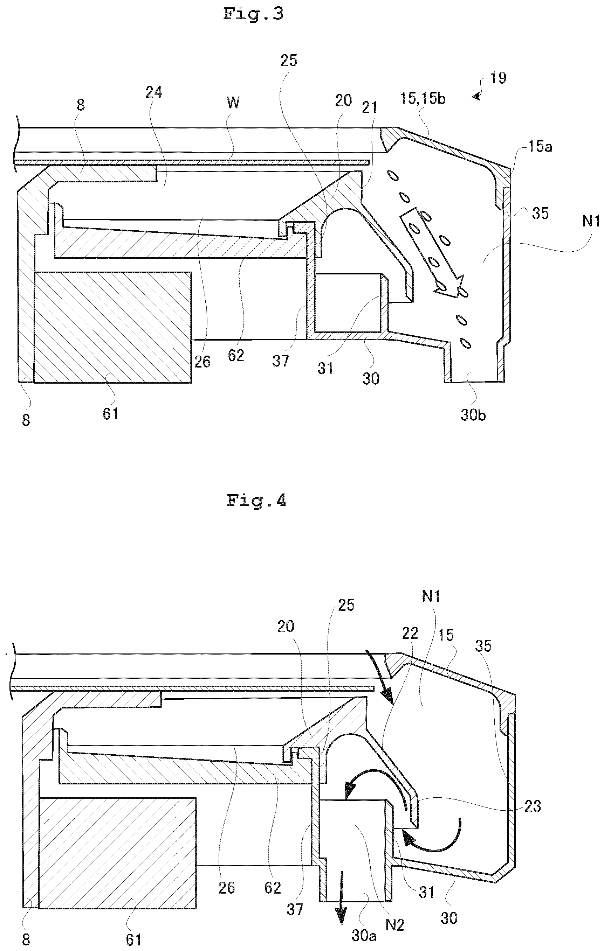

FIG. 3 illustrates a state in which the substrate W shakes off chemical liquid discharged toward the rotating substrate W in substrate processing in the resist chamber 41. Chemical liquid at an end portion of the substrate W rotating at a low speed is blown off in an obliquely downward direction from the end portion of the substrate W, with the airflow from the upper side to the lower side. A position of a central axis of the liquid discharge opening 30b is set so as to coincide with a position that allows the chemical liquid scattered when the substrate W rotates at a low speed to reach the bottom plate 32. The airflow in the cup 19 is generated by exhaust of an atmosphere through the exhaust opening 30a. Whereas, when the substrate W is rotated at a high speed, the chemical liquid shaken off from the substrate W reaches the outer tapered portion 15b of the upper cup 15. As described above, the scattering direction of the chemical liquid shaken off from the substrate W changes between the high-speed rotation and the low-speed rotation of the substrate W.

The circular exhaust opening 30a corresponds to an exhaust port in the present invention. The exhaust opening 30a is connected to an exhaust device attached to the substrate processing apparatus 1, and is an atmosphere outlet for the resist chamber 41. The exhaust opening 30a is provided at a position closer to the inner housing 37 than the lower wall portion 31. The exhaust opening 30a is communicatively connected with the gas recovery chamber N2 to exhaust the atmosphere in the cup 19, and is provided in the bottom plate 32. The atmosphere is, for example, in a state in which gas containing minute droplets, vapor of liquid, or the like is mixed with liquid. Note that the exhaust opening 30a may be connected to an exhaust lift outside the substrate processing system, for example, in a factory.

The lower wall portion 31 provided on the bottom plate 32 has a role of separating gas and liquid when the atmosphere mixed with the chemical liquid is expelled to the outside of the resist chamber 41. That is, the chemical liquid flowing toward the liquid discharge opening 30b does not flow toward the exhaust opening 30a over the lower wall portion 31.

Whereas, the lower wall portion 31 has a function of removing the chemical liquid from the atmosphere mixed with the chemical liquid, in cooperation with a middle wall portion 23 of the middle cup 20. Details of this function will be described later.

The middle cup 20 is sandwiched between the upper cup 15 and the lower cup 30 from above and below. The middle cup 20 is a member to be fitted to the inner housing 37 of the lower cup 30, and includes a cylindrical fitting wall portion 25 to be fitted to the inner housing 37 of the lower cup 30. The middle cup 20 has an inclined portion 24 facing the spin chuck 8. Therefore, the inclined portion 24 has an inclined surface formed so as to be away from the spin chuck 8 from the lower side to the upper side. A lower end portion of the inclined portion 24 is connected to a cylindrical wall portion 26 defining an inner surface of the middle cup 20. Whereas, a top portion of the inclined portion 24 is also an upper end of the middle cup 20.

A configuration of the middle cup 20 will be further described. The top portion of the inclined portion 24 is connected to a vertical wall portion 21 facing the outer housing 35 of the lower cup 30. The vertical wall portion 21 is a cylindrical member to which an upper end of an inner tapered portion 22 of the middle cup 20 is connected. In addition, the vertical wall portion 21 extends from the top portion of the inclined portion 24 as a starting point, in the vertical direction away from the substrate W held by the spin chuck 8. Therefore, the vertical wall portion 21 is configured such that the chemical liquid scattered from the end portion of the substrate W does not adhere as much as possible. In addition, the vertical wall portion 21 is provided at a position closer to a rotation axis A1 of the spin chuck 8 than the end portion of the substrate W held by the spin chuck 8. An outer diameter of the vertical wall portion 21 is smaller than a diameter of the substrate. That is, for the vertical wall portion 21, the substrate W held by the spin chuck 8 functions like an umbrella, and the chemical liquid discharged from the nozzle 10 toward the substrate W is less likely to reach the vertical wall portion 21.

As described above, the middle cup 20 has a configuration in which the chemical liquid from the nozzle 10 is less likely to reach. When the chemical liquid reaches the middle cup 20, the middle cup 20 is contaminated by the chemical liquid, and the chemical liquid solidifies and adheres to the middle cup 20 eventually. A shape of the middle cup 20 of the present example is devised by providing the vertical wall portion 21 or the like so as not to cause such a problem. A reason for providing the vertical wall portion 21 is to protect the inner tapered portion 22 from the chemical liquid, by installing the inner tapered portion 22 described later as downward as possible.

Next, the inner tapered portion 22 of the middle cup 20 will be described. The inner tapered portion 22 is configured to connect the vertical wall portion 21 and the middle wall portion 23 to be described later. The inner tapered portion 22 is one of members constituting the middle cup 20, and is located at a position connected to the lower portion of the vertical wall portion 21. The inner tapered portion 22 has a ring shape, and has a diameter gradually decreasing upward. A lower end of the inner tapered portion 22 is connected to the middle wall portion 23 having a cylindrical shape.

The middle wall portion 23 is a cylindrical member provided to face the lower wall portion 31 on a radially outer side of the lower wall portion 31 of the lower cup 30, and has a lower end terminating at a middle position of the liquid recovery chamber N1 and an upper end terminating at a position facing the upper end of the lower wall portion 31. The inner tapered portion 22 is connected from the upper end of the middle wall portion 23.

### <9. Gas-liquid Separation Mechanism>

The middle wall portion 23 of the middle cup 20 and the lower wall portion 31 of the lower cup 30 have a function of extracting gas alone from the atmosphere mixed with the chemical liquid in cooperation with each other. This point will be described.

FIG. 4 illustrates a flow of an atmosphere generated by exhaust of the atmosphere during substrate processing. The atmosphere above the resist chamber 41 first passes through a first flow path M1 including the upper cup 15 and the end portion of the substrate W, and reaches the liquid recovery chamber N1 of the cup 19. Then, a flow direction of the atmosphere is changed by the lower wall portion 31 of the lower cup 30, and the atmosphere passes through a second flow path M2 between the lower wall portion 31 and the middle wall portion 23 of the middle cup 20. Then, the flow direction of the atmosphere is changed by the inner tapered portion 22 of the middle cup 20, and the atmosphere reaches the exhaust opening 30a via the gas recovery chamber N2.

As described above, outside air located on the upper surface of the substrate W is taken into the liquid recovery chamber N1 in the cup 19 through the first flow path M1 which is a ring-shaped gap located between the outer tapered portion 15b of the upper cup 15 and the substrate W held by the spin chuck 8. The outside air taken into the liquid recovery chamber N1 is taken into the gas recovery chamber N2 through the second flow path M2 which is a cylindrical gap located between the middle wall portion 23 and the lower wall portion 31 of the lower cup 30, and the outside air is discharged from the exhaust opening 30a.

While following such a path, the atmosphere mixed with the chemical liquid becomes gas alone and reaches the exhaust opening 30a. That is, when the atmosphere mixed with the chemical liquid collides with the lower wall portion 31 of the lower cup 30, the flow direction of the atmosphere greatly changes from a horizontal direction to the vertical direction. The chemical liquid mixed in the atmosphere collides with the lower wall portion 31, and is trapped without following the rapid flow change.

The lower wall portion 31 and the middle wall portion 23 are in a positional relationship of facing each other, thereby forming a channel sandwiched between both members. By forming such a narrow channel extending in the vertical direction, the rapid change in the flow of the atmosphere can be reliably generated. That is, the lower wall portion 31 of the lower cup 30 and the middle wall portion 23 of the middle cup 20 are configured to perform gas-liquid separation in cooperation with each other on the atmosphere mixed with the chemical liquid.

### <10. Other Configurations in resist chamber>

As illustrated in FIG. 2, the resist chamber 41 further includes a ring-shaped support member 62 that supports the middle cup 20 and the lower cup 30, and a shaft holding member 61 that holds a rotating shaft of the spin chuck 8. The rotation shaft of the spin chuck 8 is connected to a motor (not illustrated), and rotation is controlled by the control unit 139 described above.

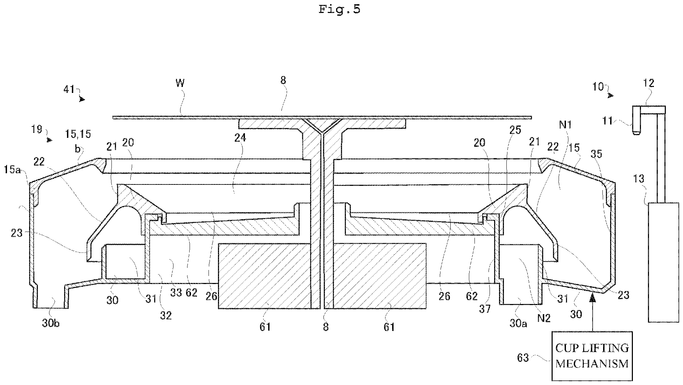

A cup lifting mechanism 63 illustrated in FIG. 5 is configured to move the cup 19 up and down with respect to the spin chuck 8. The cup lifting mechanism 63 can change a state between a state in which the cup 19 is moved up to enable substrate processing as illustrated in FIG. 2 and a state in which the cup 19 is moved down to enable transfer of the substrate W by the first center robot C1 as illustrated in FIG. 5.

### <11. Flow Path Cross-Sectional Area>

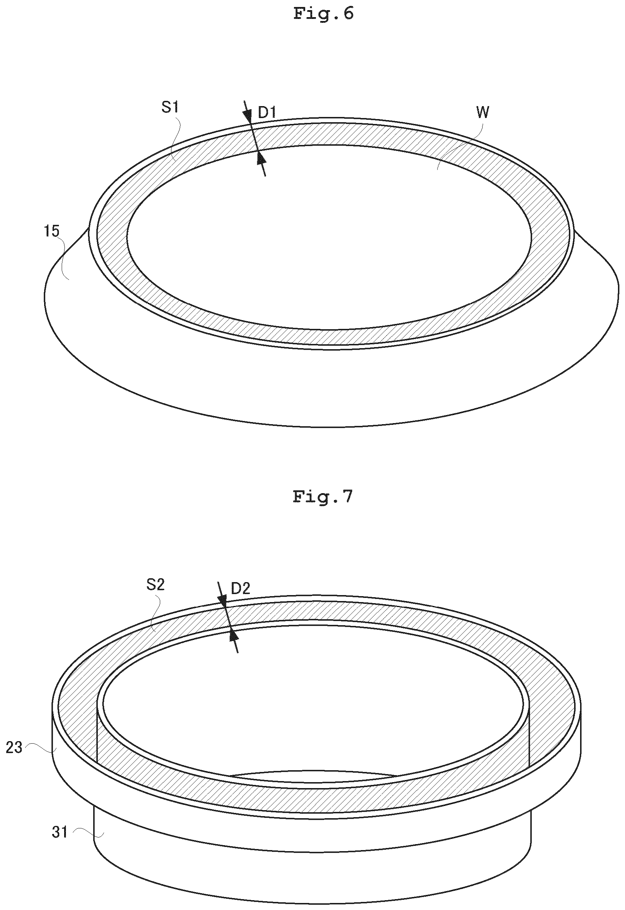

The lower wall portion 31 of the lower cup 30 and the middle wall portion 23 of the middle cup 20 face each other in the horizontal direction, and are separated from each other to form the second flow path M2 illustrated in FIG. 4. A flow path cross-sectional area S2 illustrated in FIG. 7 of the second flow path M2 is configured to be the same as a cross-sectional area S1 illustrated in FIG. 6 of the first flow path M1 illustrated in FIG. 4 which is a ring-shaped gap located between the outer tapered portion 15b of the upper cup 15 and the substrate W held by the spin chuck 8.

By making the cross-sectional area S1 and the flow path cross-sectional area S2 the same as each other, the flow path cross-sectional area S2 can be reduced without deteriorating an exhaust force of the chemical liquid scattered from the substrate W. First, the flow path cross-sectional area S2 is preferably small from the viewpoint of protecting the middle cup 20 from splashes of the chemical liquid. This is because the size of the middle cup 20 can be reduced as much as the flow path cross-sectional area S2 is smaller, so that it is possible to suppress adhesion of splashes of the chemical liquid to the middle cup 20. However, if the flow path cross-sectional area S2 is made smaller than the cross-sectional area S1, a speed of the atmosphere flowing through the gap between the end portion of the substrate W held by the spin chuck 8 and the upper cup 15 becomes slow. This is because the flow of the atmosphere is stagnated between the lower wall portion 31 and the middle wall portion 23 as much as the flow path cross-sectional area S2 decreases. According to the present example, such a problem does not occur since the flow path cross-sectional area S2 is equal to the cross-sectional area S1, and a flow rate of the atmosphere in the gap between the lower wall portion 31 and the middle wall portion 23 is equal to a flow rate of the atmosphere in the gap between the end portion of the substrate W held by the spin chuck 8 and the upper cup 15.

According to this specification, dimensions of individual members are defined such that the flow path cross-sectional area S2 is equal to the cross-sectional area S1. In this specification, "the flow path cross-sectional area S2 is equal to the cross-sectional area S1" includes not only a state in which the size of the flow path cross-sectional area S2 coincides with the size of the cross-sectional area S1, but also a state in which the size of the flow path cross-sectional area S2 coincides with a size from 1 time to 1.2 times the cross-sectional area S1.

FIG. 6 illustrates an effect of the configuration of the present example. That is, in the resist chamber 41 during the substrate processing, a ring-shaped gap is generated between the substrate W and the upper cup 15. When the atmosphere is exhausted from the exhaust opening 30a of the lower cup 30, the atmosphere flows toward the inside of the cup 19 through the ring-shaped gap. A cross-sectional area of the gap is defined as S1.

FIG. 7 also illustrates an effect of the configuration of the present example. That is, in the resist chamber 41 during the substrate processing, a cylindrical gap is generated between the middle wall portion 23 of the middle cup 20 and the lower cup 30. When the atmosphere is exhausted from the exhaust opening 30a of the lower cup 30, the atmosphere flows toward the exhaust opening 30a through the cylindrical gap. A cross-sectional area of the gap is defined as S2.

As a specific configuration of the present invention, an inclination angle of the inner tapered portion 22 is preferably about 52°. With this configuration, most of the chemical liquid scattered from the end portion of the substrate W during the substrate processing does not reach the inner tapered portion 22.

### <12. Positional Relationship between Liquid Discharge Port and Inner Tapered Portion>

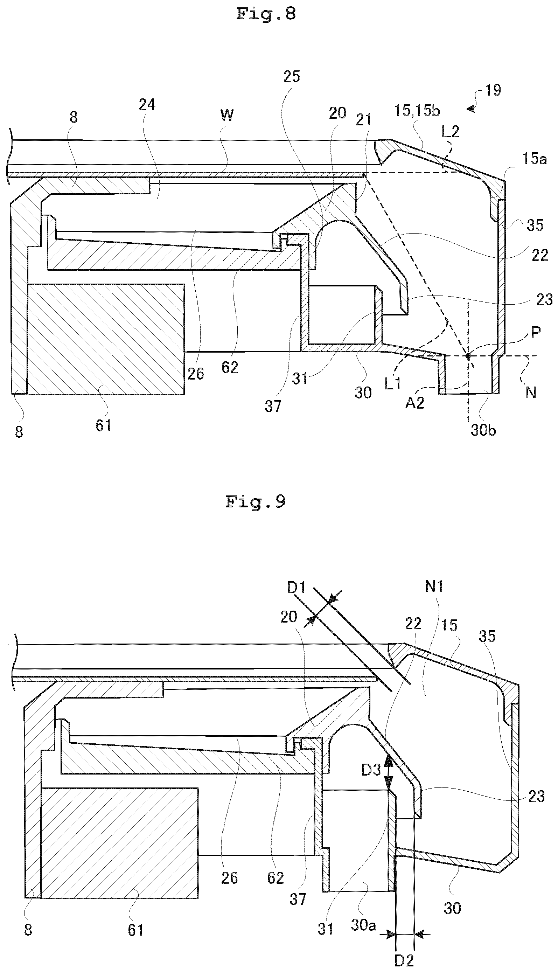

Next, a positional relationship between the liquid discharge opening 30b in the lower cup 30 and the inner tapered portion 22 in the middle cup 20 will be described. As illustrated in FIG. 8, a reference point P serving as a reference of a position is determined in the liquid discharge opening 30b. The reference point P is located at a position where a plane N where the bottom plate 32 of the lower cup 30 is located intersects with a central axis A2 of the liquid discharge port having a circular cylindrical cross section. The reference point P in the present example is a portion where most of the chemical liquid scattered from the substrate W during the chemical liquid processing reaches. The middle cup 20 in the present example, particularly the inner tapered portion 22 is located closer to the spin chuck 8 than a straight line L1 connecting an end portion of the substrate W and the reference point P. That is, the inner tapered portion 22 is not on a trajectory of the chemical liquid from the substrate W toward the reference point P during the substrate processing. With such a configuration, during the substrate processing with rotation of the substrate W at a low speed, most of the chemical liquid reaches the reference point P without reaching the inner tapered portion 22. An inclination angle of the straight line L1 is 61°. Note that the actual chemical liquid reaches any position of a virtual circle centered on the spin chuck including the reference point P. As described above, the entire middle cup 20 is located inside the straight line L1 connecting the center of the liquid discharge opening 30b and an end portion of a substrate held by the spin chuck 8. During the substrate processing with rotation of the substrate W at a high speed, droplets shaken off from the substrate W are scattered in a horizontal direction L2 and reach the outer tapered portion 15b of the upper cup 15. Therefore, during the substrate processing, the droplets scattered from the substrate W fly away in either the horizontal direction indicated by the straight line L2 or a direction inclined from the straight line L2 by a predetermined angle. In the present example, the predetermined angle is 61° or less. Therefore, the straight line L1 indicates a direction most deviated from the horizontal direction in the scattering direction of the droplets from the substrate W. According to the present example, most of the droplets scattered from the end portion of the substrate W do not reach the inner tapered portion 22 of the middle cup 20, regardless of the rotation speed of the substrate W during the substrate processing.

### <13. Effects of Invention>

As described above, the resist chamber 41 includes the outer housing 35 having a cylindrical shape, and the outer tapered portion 15b having a ring shape, located upward of the outer housing 35, and having the inner diameter gradually decreasing upward from the inner diameter of the outer housing 35. A gap between the outer tapered portion 15b and the substrate W held by the spin chuck 8 serves as the first flow path M1. In the resist chamber 41, a gap between the middle wall portion 23 of the middle cup 20 and the lower wall portion 31 of the lower cup 30 serves as the second flow path M2. Then, the flow path cross-sectional area S2 of the second flow path M2 is equal to the cross-sectional area S1 of the first flow path M1. With this configuration, the middle cup 20 can be made as small as possible.

That is, in order to inhibit contamination of the middle cup 20 due to liquid discharged from the nozzle 10, it suffices that the middle cup 20 is made as small as possible. Specifically, the middle wall portion 23 of the middle cup 20 may be simply brought closer to the lower wall portion 31 of the lower cup 30 to make the middle cup smaller. A lower limit of the size of the middle cup 20 can be set by determining a dimension of the middle wall portion 23 on the basis of the cross-sectional area of the first flow path M1, which is a gap between the outer tapered portion 15b of the upper cup 15 and the substrate W held by the spin chuck 8. If the size of the middle cup 20 is reduced independently of the cross-sectional area of the first flow path M1, an airflow in the gap between the outer tapered portion 15b of the upper cup 15 and the substrate W held by the spin chuck 8 is weakened. According to the present invention, such a phenomenon does not occur. Therefore, according to the present invention, it is possible to provide the resist chamber 41 capable of suppressing adhesion of stains to the middle cup 20 while appropriately executing substrate processing.

According to the configuration described above, the bottom surface of the lower cup 30 includes the liquid discharge opening 30b provided at a position farther from the spin chuck 8 than the lower wall portion 31 and configured to discharge liquid in the cup, and the middle cup 20 is entirely located inside the straight line L1 connecting the center of the liquid discharge opening 30b and the end portion of the substrate W held by the spin chuck 8. That is, most of the chemical liquid during the substrate processing is discharged from the liquid discharge opening 30b without reaching the inner tapered portion 22. With this configuration, the middle cup 20 can be located away from a flow of the liquid when the liquid in the cup is discharged. Therefore, according to the present configuration, it is possible to provide the resist chamber 41 capable of suppressing adhesion of stains to the middle cup 20.

According to the configuration described above, the middle cup 20 includes the vertical wall portion 21 having a cylindrical shape and connected with the upper end of the inner tapered portion, and the outer diameter of the vertical wall portion 21 is smaller than the diameter of the substrate W. With this configuration, liquid scattered from the end portion of the substrate W goes toward the lower cup 30 while avoiding the vertical wall portion 21. With this configuration, it is possible to provide the resist chamber 41 having a configuration in which the liquid does not reach the middle cup 20 as much as possible. According to the present invention, since the liquid does not reach the middle cup 20 as much as possible, the frequency of washing the middle cup 20 can be reduced. This makes it possible to reduce the frequency of the cleaning processing that requires disassembly of the cup 19, so that the substrate processing apparatus 1 with high processing efficiency can be provided. According to the present example, it is possible to further reduce the consumption of the chemical liquid necessary for cleaning the cup 19.

### <14. Modification>

The present invention is not limited to the configuration described above, and can be modified as follows.

### <Modification 1>

In the present modification, a speed of the airflow at the end portion of the substrate W is maintained by making a distance D1 equal to a separation distance D2. Hereinafter, this configuration will be specifically described.

According to the present modification, as illustrated in FIG. 9, the separation distance D2 between the lower wall portion 31 and the middle wall portion 23 is determined on the basis of the distance D1 from the end portion of the substrate W held by the spin chuck 8 to the upper cup 15. That is, the separation distance D2 is equal to the distance D1. In this specification, "the separation distance D2 is equal to the distance D1" includes not only a case where a length of the separation distance D2 coincides with a length of the distance D1, but also a state where the length of the separation distance D2 coincides with a length from 1 time to 1.2 times the distance D1.

With such a configuration, in a case where the first flow path M1 and the second flow path M2 are separated from each other in the vertical direction, the flow path cross-sectional area S2 can be made to coincide with the cross-sectional area S1.

A distance D3 in the vertical direction between the lower wall portion 31 and the inner tapered portion 22 is set to be larger than the distance D1. With this configuration, the flow of the atmosphere between the lower wall portion 31 and the inner tapered portion 22 does not become stagnant, and the speed of the atmosphere flowing through the gap between the end portion of the substrate W held by the spin chuck 8 and the upper cup 15 does not become slow.

According to the configuration described above, the distance D3 in the vertical direction between the inner tapered portion 22 of the middle cup 20 and the lower wall portion 31 of the lower cup 30 is longer than the separation distance D2. With this configuration, the airflow in the gap between the inner tapered portion 22 of the middle cup 20 and the lower wall portion 31 of the lower cup 30 can be made weaker than the airflow in the gap between the middle wall portion 23 and the lower wall portion 31. That is, with such a configuration, it is possible to provide the resist chamber 41 in which the airflow in the gap between the outer tapered portion 15b of the upper cup 15 and the substrate W held by the spin chuck 8 is reliably maintained.

## Claims

1. A substrate processing apparatus comprising:
a spin chuck (9) that is rotatable while holding a substrate;
a nozzle (10) located upward of the spin chuck (9) and configured to discharge liquid; and
a cup (19) provided to surround the spin chuck (9), wherein
the cup (19) includes an upper cup (15), a lower cup (30), and a middle cup (20),
the upper cup (15) includes an outer tapered portion having a ring shape and having an inner diameter gradually decreasing upward,
the lower cup (30) includes: a bottom surface having a ring shape; an outer housing having a cylindrical shape, provided to extend upward from an outer edge portion of the bottom surface, and having an upper portion connected to a lower portion of the upper cup (15); an inner housing having a cylindrical shape and provided to extend upward from an inner edge portion of the bottom surface; and a lower wall portion having a cylindrical shape and provided to extend upward from the bottom surface between the outer housing and the inner housing, a space formed by being sandwiched between the outer housing and the lower wall portion serves as a liquid recovery chamber, a space sandwiched between the inner housing and the lower wall portion serves as a gas recovery chamber, and the bottom surface is provided with an exhaust port communicatively connected to the gas recovery chamber and configured to exhaust an atmosphere in the cup (19),
the middle cup (20) is located at a position sandwiched from above and below by the upper cup (15) and the lower cup (30), and includes: a middle wall portion having a cylindrical shape, provided to face the lower wall portion of the lower cup (30) on a radially outer side of the lower wall portion, having a lower end terminating at a middle position of the liquid recovery chamber, and having an upper end terminating at a position facing an upper end of the lower wall portion; and an inner tapered portion having a ring shape, connected from an upper end of the middle wall portion, and having a diameter gradually decreasing upward, and
outside air is taken into the liquid recovery chamber in the cup (19) through a first flow path that is a ring-shaped gap located between the outer tapered portion in the upper cup (15) and the substrate held by the spin chuck (9), and outside air taken into the liquid recovery chamber is taken into the gas recovery chamber through a second flow path and is discharged from the exhaust port, the second flow path being a cylindrical gap located between the middle wall portion and the lower wall portion in the lower cup (30), and a flow path cross-sectional area of the second flow path is equal to a cross-sectional area of the first flow path.

2. The substrate processing apparatus according to claim 1, wherein
the bottom surface of the lower cup (30) includes a liquid discharge port provided at a position farther from the spin chuck (9) than the lower wall portion and configured to discharge liquid in the cup (19), and
the middle cup (20) is entirely located inside the spin chuck (9) with reference to a straight line connecting a center of the liquid discharge port and an end portion of a substrate held by the spin chuck (9).

3. The substrate processing apparatus according to claim 1, wherein
the middle cup (20) includes a vertical wall portion having a cylindrical shape and connected with an upper end of the inner tapered portion, and
an outer diameter of the vertical wall portion is smaller than a diameter of the substrate.

4. A substrate processing system comprising the substrate processing apparatus according to claim 1, the substrate processing system comprising:
a robot configured to take in and out a substrate to and from the substrate processing apparatus.
